# EUROPEAN PATENT APPLICATION

(11) **EP 3 907 766 A1**
(43) Date of publication of application: **10.11.2021**
(21) Application number: 21174069.1
(22) Date of filing: 14.09.2017
(51) Int. Cl.: H01L 31/05, H01L 31/02, H01L 31/0352, H01L 31/042, H01L 31/044, H01L 31/048, H01L 31/0687

(54) **SOLAR CELL ARRAY CONNECTIONS USING CORNER CONDUCTORS**

(30) Priority: 14.09.2016 US 201662394636 P; 14.09.2016 US 201662394616 P; 14.09.2016 US 201662394623 P; 14.09.2016 US 201662394627 P; 14.09.2016 US 201662394629 P; 14.09.2016 US 201662394632 P; 14.09.2016 US 201662394649 P; 14.09.2016 US 201662394666 P; 14.09.2016 US 201662394667 P; 14.09.2016 US 201662394671 P; 14.09.2016 US 201662394641 P; 14.09.2016 US 201662394672 P; 06.07.2017 US 201715643274; 06.07.2017 US 201715643277; 06.07.2017 US 201715643279; 06.07.2017 US 201715643282; 06.07.2017 US 201715643285; 06.07.2017 US 201715643287; 06.07.2017 US 201715643289
(62) Divisional of application: 17191168.8
(71) Applicant: The Boeing Company, Chicago, IL 60606-1596 (US)
(72) Inventor: Rehder, Eric, Chicago, 60606-1596 (US)
(74) Representative: Witte, Weller & Partner Patentanwälte mbB

(57) **Abstract**

A solar cell array is comprised of at least one solar cell and a substrate for the solar cell. The solar cell has at least one cropped corner that defines a corner region, wherein the corner region includes at least one contact for making an electrical connection to the solar cell. The contact comprises a front contact on a front side of the solar cell and/or a back contact on a back side of the solar cell, wherein the contact extends into the corner region. The solar cell is attached to the substrate such that corner regions of adjacent solar cells are aligned, thereby exposing an area of the substrate where electrical connections between the solar cells are made using corner conductors. The electrical connections are up/down and/or left/right series connections that determine a flow of current through the cells.

## Description

### BACKGROUND INFORMATION

### 1. Field.

The disclosure is related generally to solar cell panels and more specifically to electrical connections made between solar cells in an array using corner conductors.

### 2. Background.

Generally, the fabrication process for solar cell arrays is highly manual and customizable. This is especially true for solar cell arrays that are spaceflight capable. There is a lack of automated means for manufacturing solar cell arrays, while preserving the ability for customization.

Typical spaceflight-capable solar cell panel assembly involves building long strings of solar cells. These strings are variable in length and can be very long, for example, up to and greater than 20 cells. Assembling such long, variable, and fragile materials is difficult, which has prevented automation of the assembly.

Existing solutions use solar cells assembled into CIC (cell, interconnect and coverglass) units. The CIC has metal foil interconnects connected to the front of the cell that extend in parallel from one side of the CIC. The CICs are located close to each other and the interconnects make connection to the bottom of an adjacent cell. Using these interconnects, the CICs are assembled into linear strings. These linear strings are built-up manually and then laid out to form a large solar cell array comprised of many strings of variable length.

Additionally, a bypass diode is used to protect the cells from reverse bias, when the cells become partially shadowed. The bypass diode generally connects the back contacts of two adjacent cells within the solar cell array.

Some small solar cell arrays attach solar cells to printed circuit board (PCBs) materials with embedded wiring. While this has some of the advantages sought for automated manufacturing, it is specific and limited in its design. As a result, they are not widely used in satellites.

When used in a satellite, the solar cell array is typically packaged as a panel. The dimensions of the panel are dictated by the needs of the satellite, including such constraints as needed power, as well as the size and shape necessary to pack and store the satellite in a launch vehicle.

Furthermore, the deployment of the panel often requires that some portions of the panel are used for the mechanical fixtures and the solar cell array must avoid these locations. In practice, the panel is generally rectangular, but its dimensions and aspect ratio vary greatly. The layout of the CICs and strings to fill this space must be highly customized for maximum power generation, which results in a fabrication process that is highly manual.

What is needed, then, is a means for promoting automated manufacturing of solar arrays, while preserving the ability for customization of solar cell arrays.

### SUMMARY

To overcome the limitations in the prior art described above, and to overcome other limitations that will become apparent upon reading and understanding the present specification, the present disclosure describes a solar cell array comprised of at least one solar cell and a substrate for the solar cell. The solar cell has at least one cropped corner that defines a corner region, wherein the corner region includes at least one contact for making an electrical connection to the solar cell. The contact comprises a front contact on a front side of the solar cell and/or a back contact on a back side of the solar cell, wherein the contact extends into the corner region. The solar cell is attached to the substrate such that corner regions of adjacent solar cells are aligned, thereby exposing an area of the substrate where electrical connections between the solar cells are made. The electrical connections are up/down and/or left/right series connections that determine a flow of current through the cells.

### DRAWINGS

Referring now to the drawings in which like reference numbers represent corresponding parts throughout:
FIGS. 1 and 2 illustrate conventional structures for solar cell panels.
FIGS. 3A and 3B illustrate an improved structure for solar cell panels, according to one example.
FIGS. 4A and 4B illustrate an improved structure for solar cell panels, according to another example.
FIG. 5 illustrates an exemplary solar cell, according to one example.
FIG. 6 illustrates the back side of the exemplary solar cell of FIG. 5.
FIG. 7 illustrates cells arranged into a two-dimensional (2D) grid of a solar cell array, according to one example.
FIG. 8 illustrates the addition of bypass diodes to one of the areas of the substrate exposed by the corner regions, according to one example.
FIG. 9 illustrates an example where the bypass diodes are applied to the back side of the cell, with an interconnect or contact extending into the corner region, according to one example.
FIG. 10 illustrates a front side view of the example of FIG. 9, where the bypass diodes are applied to the back side of the cell, with the interconnect or contact extending into the corner region, according to one example.
FIG. 11 illustrates the cells of FIG. 9 and 10 assembled into the 2D grid of the array, where the bypass diodes are applied to the back side of the cells, with the interconnects or contacts extending into the corner regions of the cells, according to one example.
FIG. 12 shows an up/down series connection, according to one example.
FIG. 13 shows a left/right series connection, according to one example.
FIG. 14 is a flowchart illustrating the steps of a fabrication method, according to one example.
FIG. 15 is a solar cell, solar cell panel, satellite and/or spacecraft resulting from the fabrication method of FIG. 14, according to one example.
FIG. 16 is an illustration of a solar panel in the form of a functional block diagram, according to one example.

### DETAILED DESCRIPTION

In the following description, reference is made to the accompanying drawings which form a part hereof, and in which is shown by way of illustration a specific example in which the disclosure may be practiced. It is to be understood that other examples may be utilized and structural changes may be made without departing from the scope of the present disclosure.

A new approach to the design of solar cell arrays, such as those used for spaceflight power applications, is based on electrical connections among the solar cells in the array.

This new approach rearranges the components of a solar cell and the arrangements of the solar cells in the array. Instead of having solar cells connected into long linear strings and then assembled onto a substrate, the solar cells are attached individually to a substrate, such that corner regions of adjacent cells are aligned on the substrate, thereby exposing an area of the substrate. Electrical connections between cells are made by corner conductors formed on or in the substrate in these corner regions. Consequently, this approach presents a solar cell array design based on individual cells.

Thus, a single laydown process and layout can be used in the fabrication of solar cell arrays. Current flow between solar cells will be assisted with conductors embedded in the substrate. These electrical connections define the specific characteristics of the solar cell array, such as its dimensions, stayout zones, and circuit terminations. This approach simplifies manufacturing, enables automation, and lowers costs and delivery times.

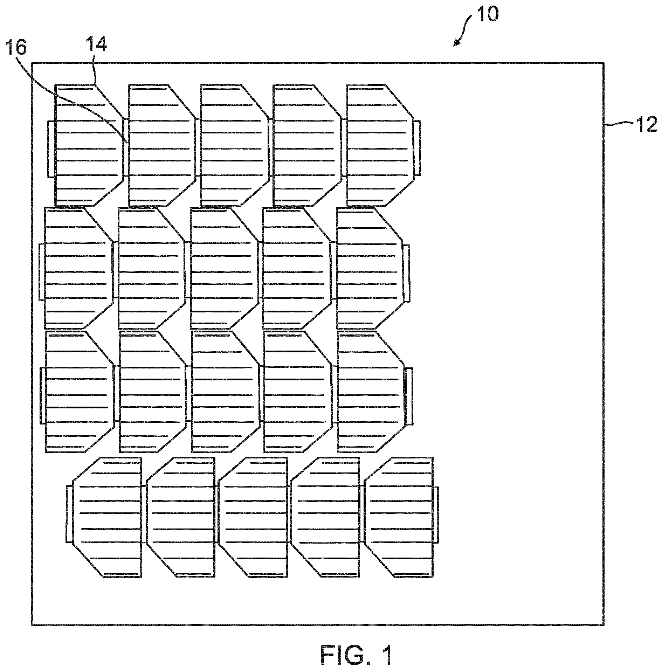

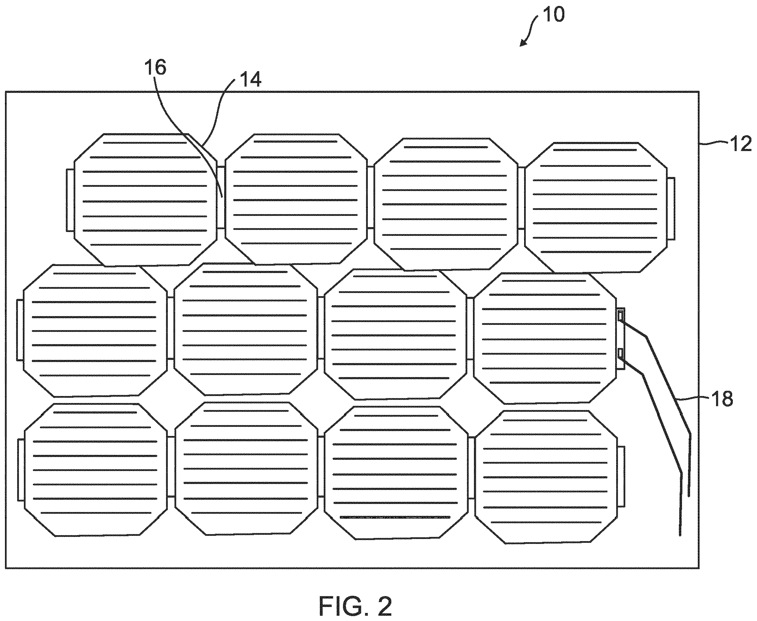

FIGS. 1 and 2 illustrate conventional devices and structures for solar cell panels 10, which include a substrate 12, a plurality of solar cells 14 arranged in an array, and electrical connectors 16 between the solar cells 14. Half size cells 14 are shown in FIG. 1 and full size cells 14 are shown in FIG. 2. Space solar cells 14 are derived from a round Germanium (Ge) substrate starting material, which is later fabricated into semi-rectangular shapes to improve dense packing onto the solar cell panel 10. This wafer is often diced into one or two solar cells 14 herein described as half size or full size solar cells 14. The electrical connectors 16 providing electrical connections between cells 14 are made along the long parallel edge between cells 14. These series connections (cell-to-cell) are completed off-substrate, as strings of connected cells 14 are built having lengths of any number of cells 14. The completed strings of cells 14 are then applied and attached to the substrate 12.

In FIG. 2, wiring 18 is attached at the end of a string of cells 14 to electrically connect the string to other strings, or to terminate the resulting circuit and bring the current off of the array of cells 14. String-to-string and circuit termination connections are typically done on the substrate 12, and typically using wiring 18. However, some small solar arrays use a PCB-type material with embedded conductors.

Adjacent strings of connected solar cells 14 can run parallel or anti-parallel. In addition, strings of connected solar cells 14 can be aligned or misaligned. There are many competing influences to the solar cell layout resulting in regions where cells are parallel or anti-parallel, aligned or misaligned.

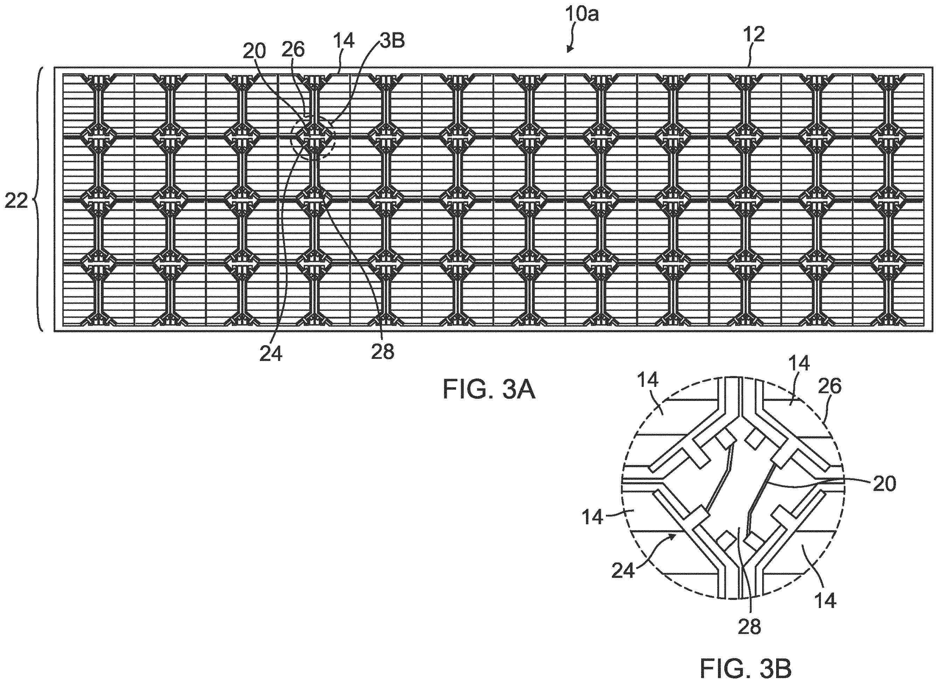

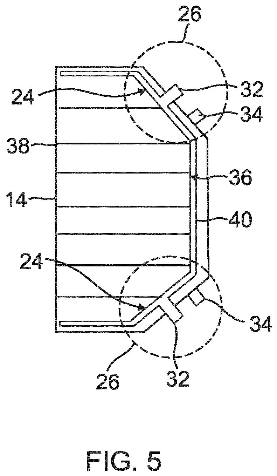

FIGS. 3A and 3B illustrate improved devices and structures for a solar cell panel 10a, according to one example, wherein FIG. 3B is an enlarged view of the details in the dashed circle in FIG. 3A. The various components of the solar cell panel 10a are shown and described in greater detail in FIGS. 5-13.

The solar cell panel 10a includes a substrate 12 having one or more corner conductors 20 thereon. In one example, the substrate 12 is a multi-layer substrate 12 comprised of one or more Kapton® (polyimide) layers separating one or more patterned metal layers. The substrate 12 may be mounted on a large rigid panel 10a similar to conventional assembles. Alternatively, substrate 12 can be mounted to a lighter more sparse frame or panel 10a for mounting or deployment.

A plurality of solar cells 14 arranged in an array 22 are attached to the substrate 12. In this example, the array 22 is comprised of ninety-six (96) cells 14 arranged in four (4) rows by twenty-four (24) columns, but it is recognized that any number of cells 14 may be used in different implementations.

The solar cells 14 have cropped corners 24 that define corner regions 26, as indicated by the dashed circle. The solar cells 14 are attached to the substrate 12, such that corner regions 26 of adjacent ones of the solar cells 14 are aligned, thereby exposing an area 28 of the substrate 12. The area 28 of the substrate 12 that is exposed includes one or more of the corner conductors 20, and one or more electrical connections between the solar cells 14 and the corner conductors 20 are made in the corner regions 26 resulting from the cropped corners24 of the solar cells 14.

In this example, the corner conductors 20 are conductive paths attached to, printed on, or integrated with the substrate 12, before and/or after the cells 14 are attached to the substrate 12, which facilitate connections between adjacent solar cells 14. The connections between the cells 14 and the corner conductors 20 are made after the cells 14 have been attached to the substrate 12.

In one example, four adjacent cells 14 are aligned on the substrate 12, such that four cropped corners 24, one from each solar cell 14, are brought together at the corner regions 26. The solar cells 14 are then individually attached to the substrate 12, wherein the solar cells 14 are placed on top of the corner conductors 20 to make the electrical connection between the solar cells 14 and the corner conductors 20.

The solar cells 14 may be applied to the substrate 12 as CIC (cell, interconnect and coverglass) units. Alternatively, a bare solar cell 14 may be applied to the substrate 12, and the coverglass later applied to the front of the solar cell 14 with a transparent adhesive. This assembly protects the solar cells 14 from damage from space radiation that would limit performance.

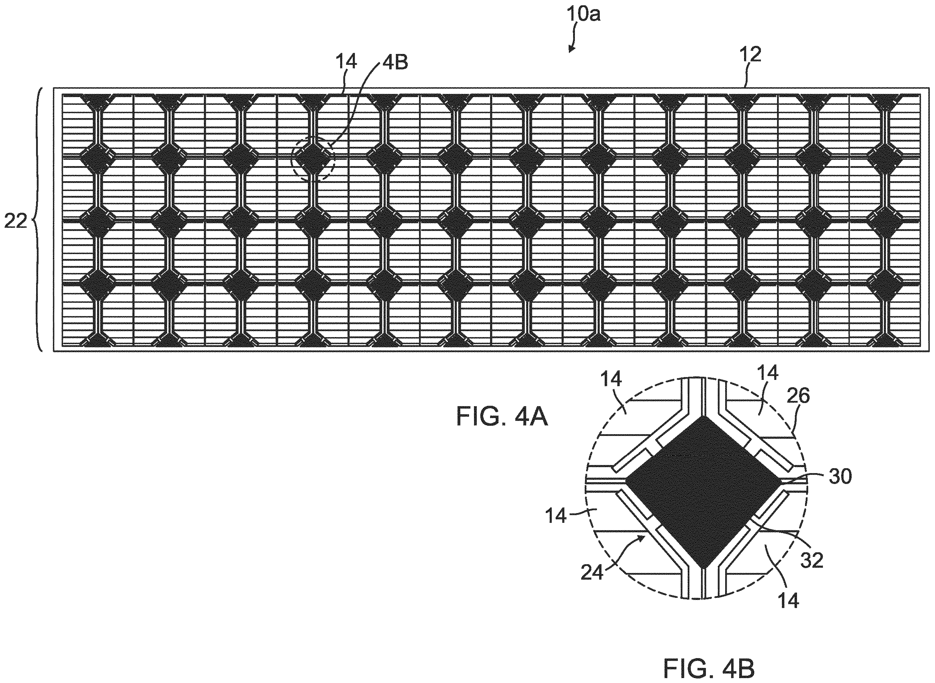

FIGS. 4A and 4B illustrate an alternative structure for the solar cell panel 10a, according to one example, wherein FIG. 4B is an enlarged view of the details in the dashed circle in FIG. 4A. In this example, only a few corner conductors 20 are printed on or integrated with the substrate 12. Instead, most of the corner conductors 20 are contained within a power routing module (PRM) 30 that is attached to the substrate 12.

FIG. 5 illustrates the front side of an exemplary solar cell 14 that may be used in the improved solar cell panel 10a of FIGS. 3A-3B and 4A-4B. The solar cell 14, which is a CIC unit, is a half-size solar cell 14. (Full-size solar cells 14 could also be used.)

The solar cell 14 is fabricated having at least one cropped corner 24 that defines a corner region 26, as indicated by the dashed circle, such that the corner region 26 resulting from the cropped corner 24 includes at least one contact 32, 34 for making an electrical connection to the solar cell 14. In the example of FIG. 5, the solar cell 14 has two cropped corners 24, each of which has both a front contact 32 on the front side of the solar cell 14 and a back contact 34 on a back side of the solar cell 14, where the contacts 32 and 34 extend into the corner region 26. (Full-size cells would have four cropped corners, each of which would have a front contact and a back contact.)

The cropped corners 24 increase utilization of the round wafer starting materials for the solar cells 14. In conventional panels, these cropped corners 24 result in unused space on the panel 10 after the solar cells 14 are attached to the substrate 12. The new approach described in this disclosure, however, utilizes this unused space. Specifically, metal foil interconnects, comprising the corner conductors 20, front contacts 32 and back contacts 34, are moved to the corner regions 26. In contrast, existing CICs have interconnects attached to the solar cell 14 front side, and connect to the back side (where connections occur) during stringing.

The current generated by the solar cell 14 is collected on the front side of the solar cell 14 by a grid 36 of thin metal fingers 38 and wider metal bus bars 40 that are connected to both of the front contacts 32. There is a balance between the addition of metal in grid 36, which reduces the light entering the solar cell 14 and its output power, and the reduced resistance of having more metal. The bus bar 40 is a low resistance conductor that carries high currents and also provides redundancy should a front contact 32 become disconnected. Optimization generally desires a short bus bar 40 running directly between the front contacts 32. Having the front contact 32 in the cropped corner 24 results in moving the bus bar 40 away from the perimeter of the solar cell 14. This is achieved while simultaneously minimizing the bus bar 40 length and light obscuration. Additionally, the fingers 38 are now shorter. This reduces parasitic resistances in the grid 36, because the length of the fingers 38 is shorter and the total current carried is less. This produces a design preference where the front contacts 32 and connecting bus bar 40 is moved to provide shorter narrow fingers 38.

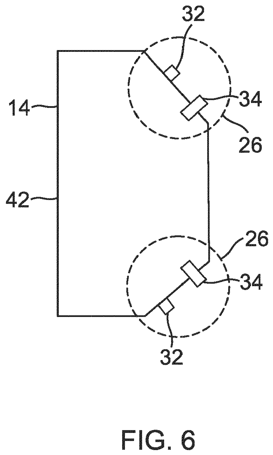

FIG. 6 illustrates the back side of the exemplary solar cell 14 of FIG. 5. The back side of the solar cell 14 is covered by a full area metal back layer 42 that is connected to both of the back contacts 34.

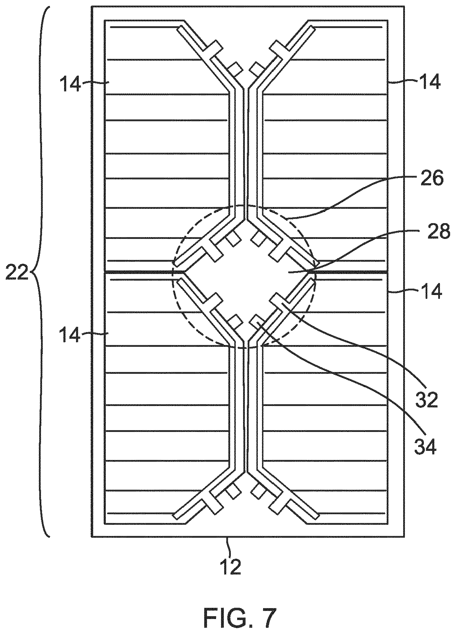

FIG. 7 illustrates solar cells 14 arranged into a two-dimensional (2D) grid for the solar cell array 22, according to one example. The array 22 comprises a plurality of solar cells 14 attached to a substrate 12, such that corner regions 26 of adjacent ones of the solar cells 14 are aligned, thereby exposing an area 28 of the substrate 12. Electrical connections (not shown) between the solar cells 14 are made in the exposed area 28 of the substrate 12 using the front contacts 32 and back contacts 34 of the solar cells 14 and corner conductors 20 (not shown) formed on or in the exposed area 28 of the substrate 12.

During assembly, the solar cells 14 are individually attached to the substrate 12. This assembly can be done directly on a support surface, i.e., the substrate 12, which can be either rigid or flexible. Alternatively, the solar cells 14 could be assembled into the 2D grid of the array 22 on a temporary support surface and then transferred to a final support surface, i.e., the substrate 12.

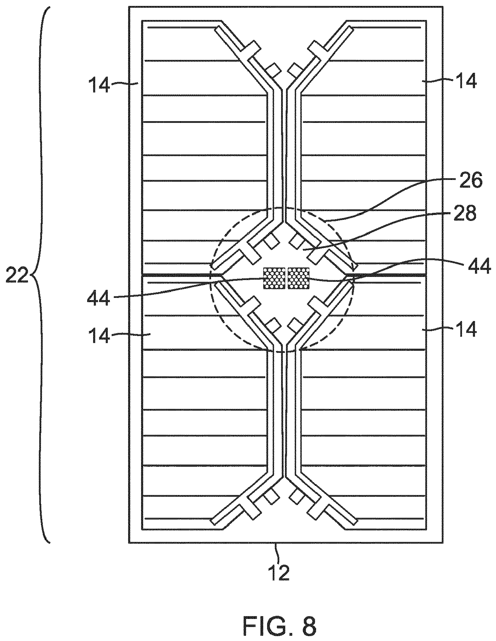

FIG. 8 illustrates an example of the array 22 where one or more bypass diodes 44 are added to the exposed area 28 of the substrate 12 in the corner regions 26, for use in one or more of the electrical connections. The bypass diodes 44 protect the solar cells 14 when the solar cells 14 become unable to generate current, which could be due to being partially shadowed, which drives the solar cells 14 into reverse bias. In one example, the bypass diodes 44 are attached to the substrate 12 in the corner regions 26 independent of the solar cells 14.

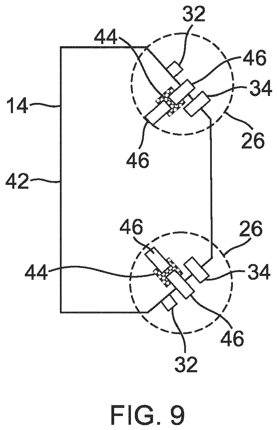

FIG. 9 illustrates an example where the bypass diode 44 is applied to the back side of the solar cell 14, with an interconnect or contact 46 for the bypass diode 44 extending into the corner region 26 between the front and back contacts 32, 34.

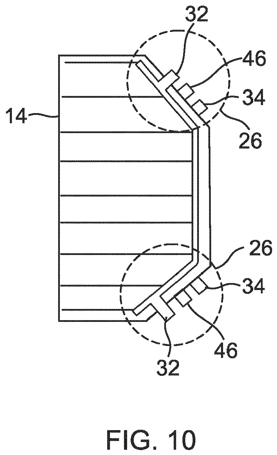

FIG. 10 illustrates a front side view of the example of FIG. 9, with the interconnect or contact 46 for the bypass diode 44 (not shown) extending into the corner region 26 between the front and back contacts 32, 34.

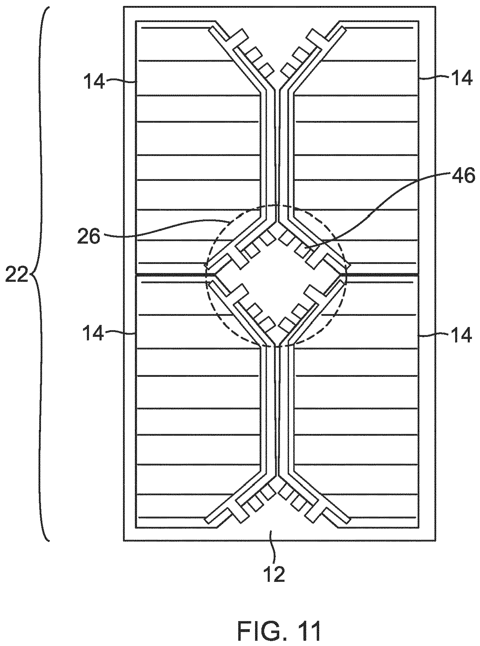

FIG. 11 illustrates the solar cells 14 of FIGS. 9 and 10 arranged into the 2D grid of the array 22 and applied to the substrate 12, where the bypass diodes 44 (not shown) are applied to the back side of the solar cells 14, with the interconnects or contacts 46 for the bypass diodes 44 extending into the corner regions 26 of the solar cells 14.

One advantage of this approach is that the layouts illustrated in FIGS. 7, 8 and 11 are generalized layouts. Specifically, these layouts can be repeated across any panel dimensions desired by a customer. This greatly simplifies assembly, rework, test, and inspection processes.

Following solar cell 14 and diode 44 placement, there is another step where customization is accomplished. The front contacts 32 and back contacts 34 in the corner regions 26 of the solar cells 14 must be connected. This can be done in many combinations in order to route current through a desired path.

After attaching solar cells 14 to the substrate 12, connections are made between the solar cells 14 and the corner conductors 20. Front and back contacts 32, 34 of the solar cells 14 are present in each corner region 26 for attachment to the corner conductors 20. Interconnects for the front and back contacts 32, 34 of each of the solar cells 14 are welded, soldered, or otherwise bonded onto the corner conductors 20 to provide a conductive path 20, 32, 34 for routing current out of the solar cells 14.

Using the corner conductors 20, any customization can be made in the electrical connections. Adjacent solar cells 14 can be electrically connected to flow current in up/down or left/right directions as desired by the specific design. Current flow can also be routed around stay-out zones as needed. The length or width of the solar cell array 22 can be set as desired. Also, the width can vary over the length of the array 22.

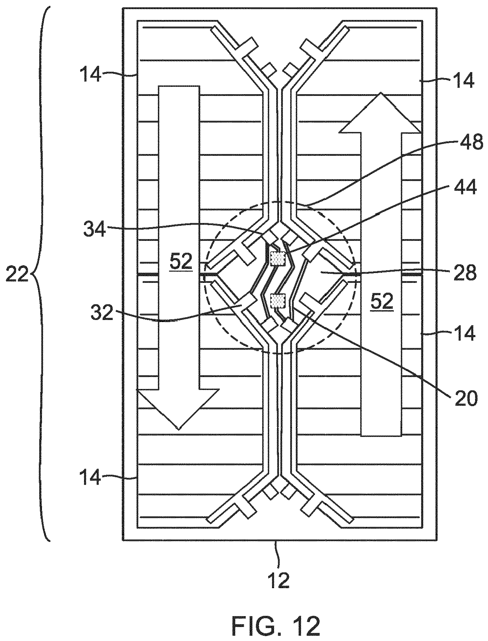

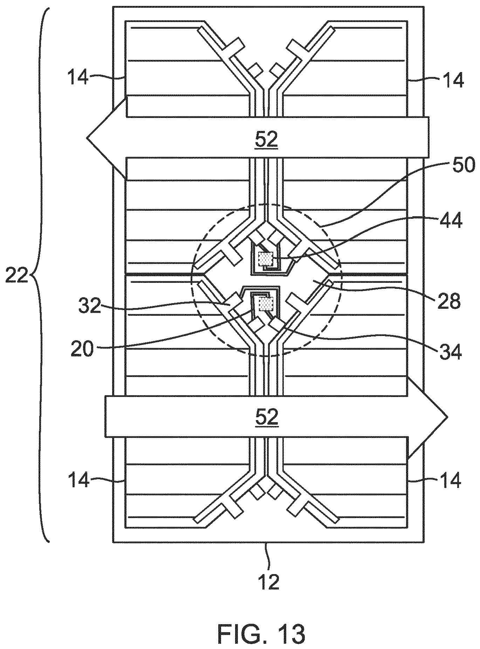

This may be accomplished by the connection schemes shown in FIGS. 12 and 13, wherein FIG. 12 shows up/down series connections 48 between the solar cells 14 of the array 22, and FIG. 13 shows left/right series connections 50 between the solar cells 14 of the array 22. In both FIGS. 12 and 13, these series connections 48, 50 are electrical connections between the front contacts 32 and back contacts 34 of the solar cells 14, and the bypass diodes 44, are made using the corner conductors 20 formed on or in the exposed areas 28 of the substrate 12. These series connections 48, 50 determine the current (power) flow, as indicated by the arrows 52, through the solar cells 14, in contrast to the assembly of large strings off-substrate.

The corner conductors 20 between solar cells 14 can be in many forms. They could be accomplished using wires that have electrical connections made on both ends, which could be from soldering, welding, conducting adhesive, or other process. In addition to wires, metal foil connectors, similar to the interconnects could be applied. Metal conductive paths or traces (not shown) can also be integrated with the substrate 12.

In summary, this new approach attaches the solar cells 14 individually to a substrate 12 such that the corner regions 26 of two, three or four adjacent solar cells 14 are aligned on the substrate 12. The solar cells 14 can be laid out so that the cropped corners 24 are aligned and the corner regions 26 are adjacent, thereby exposing an area of the substrate 12. Electrical connections between solar cells 14 are made in these corner regions 26 between front contacts 32 and back contacts 34 on the solar cells 14, bypass diodes 44, and corner conductors 20 on or in the exposed area 28 of the substrate 12, wherein these conductive paths are used to create a string of cells in a series connection 48, 50 comprising a circuit.

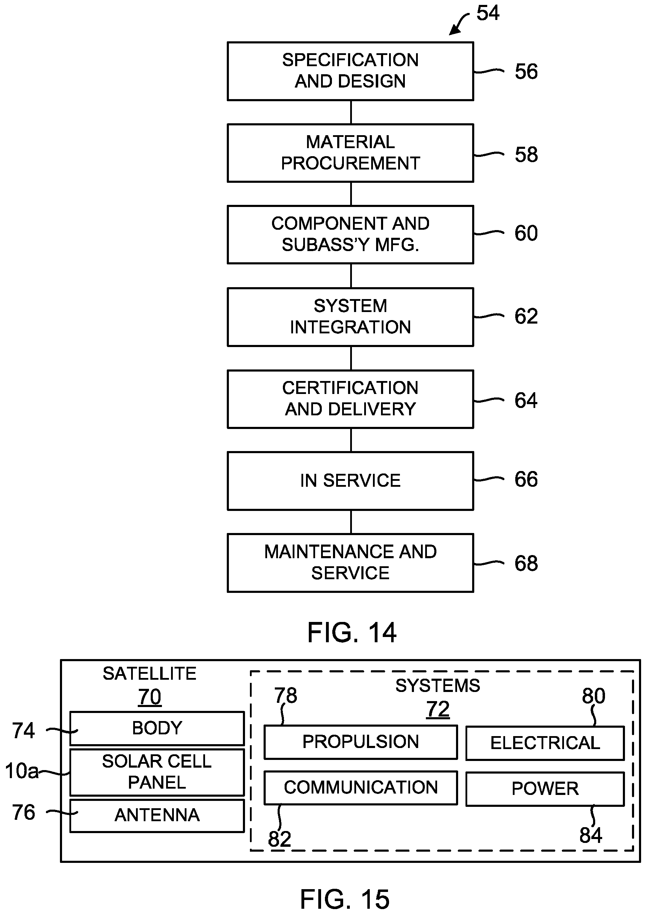

Examples of the disclosure may be described in the context of a method 54 of fabricating a solar cell, solar cell panel and/or satellite, comprising steps 56-68, as shown in FIG. 14, wherein the resulting satellite 70 having a solar cell panel 10a comprised of solar cells 14 are shown in FIG. 15.

As illustrated in FIG. 14, during pre-production, exemplary method 54 may include specification and design 56 of the solar cell 14, solar cell panel 10a and/or satellite 70, and material procurement 58 for same. During production, component and subassembly manufacturing 60 and system integration 62 of the solar cell 14, solar cell panel 10a and/or satellite 70 takes place, which include fabricating the solar cell 14, solar cell panel 10a and/or satellite 70. Thereafter, the solar cell 14, solar cell panel 10a and/or satellite 70 may go through certification and delivery 64 in order to be placed in service 66. The solar cell 14, solar cell panel 10a and/or satellite 70 may also be scheduled for maintenance and service 68 (which includes modification, reconfiguration, refurbishment, and so on), before being launched.

Each of the processes of method 54 may be performed or carried out by a system integrator, a third party, and/or an operator (e.g., a customer). For the purposes of this description, a system integrator may include without limitation any number of solar cell, solar cell panel, satellite or spacecraft manufacturers and major-system subcontractors; a third party may include without limitation any number of venders, subcontractors, and suppliers; and an operator may be a satellite company, military entity, service organization, and so on.

As shown in FIG. 15, a satellite 70 fabricated by exemplary method 54 may include a body 74, solar cell panels 10a comprised of solar cells 14, and antenna 76. Examples of the systems 72 included with the satellite 70 include, but are not limited to, one or more of a propulsion system 78, an electrical system 80, a communications system 82, and a power system 84. Any number of other systems also may be included.

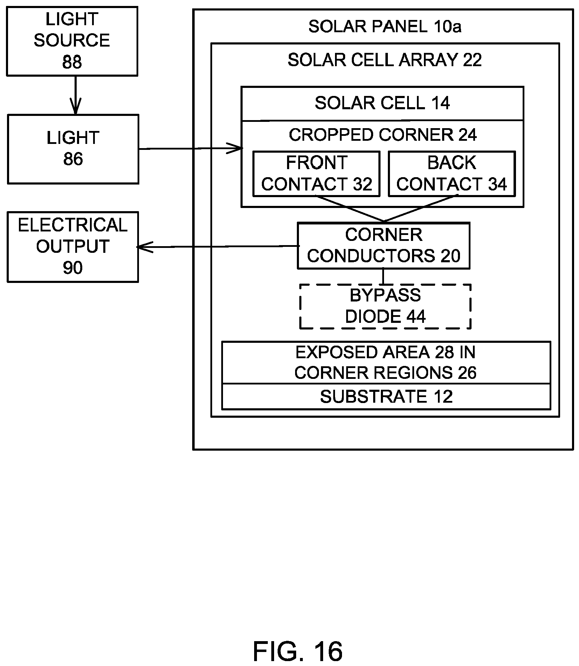

FIG. 16 is an illustration of the solar cell panel 10a in the form of a functional block diagram, according to one example. The solar cell panel 10a is comprised of the solar cell array 22, which is comprised of one or more of the solar cells 14 individually attached to the substrate 12. Each of the solar cells 14 absorbs light 86 from a light source 88 and generates an electrical output 90 in response thereto.

At least one of the solar cells 14 has at least one cropped corner 24 that defines a corner region 26, such that an area 28 of the substrate 12 remains exposed when the solar cell 14 is attached to the substrate 12. When a plurality of solar cells 14 are attached to the substrate 12, the corner regions 26 of adjacent ones of the solar cells 14 are aligned, thereby exposing the area 28 of the substrate 12.

The area 28 of the substrate 12 that remains exposed includes one or more corner conductors 20 attached to, printed on, or integrated with the substrate 12, and one or more electrical connections between the solar cells 14 and the corner conductors 20 are made in a corner region 26 resulting from the cropped corner 24 of the at least one of the solar cells 14.

The corner region 26 resulting from the cropped corner 24 includes at least one contact, for example, a front contact 32 on a front side of the solar cell 14 and/or a back contact 34 on a back side of the solar cell 14, for making the electrical connections between the corner conductors 20 and the solar cell 14. The electrical connections may comprise up/down or left/right series connections that determine a flow of power through the solar cells 14, and may include one or more bypass diodes 44.

The description of the examples set forth above has been presented for purposes of illustration and description, and is not intended to be exhaustive or limited to the examples described. Many alternatives, modifications and variations may be used in place of the specific elements described above.

To facilitate the electrical connections, it can be advantageous to have corner conductors 20 fabricated onto or within the substrate 12 before the solar cells 14 are attached. This would be somewhat similar to a PCB where thin metal traces are present. In addition, multiple current pathways can be built into the corner conductors 20. Moreover, one or more conductive jumpers (not shown) may be added to the corner conductors 20 to determine which pathways are used. Alternatively, one or more conductive pathways may be removed from the corner regions to facilitate the determination of the current pathways between solar cells 14.

Preferably, the substrate 12 includes conductive paths throughout, including conductive paths on its surface (e.g., the corner conductors 20), beneath its surface and beneath the plane of the solar cells 14 (not shown), or both on its surface and beneath its surface. The conductive paths, such as the corner conductors 20, are electrically insulated from the solar cells 14. In addition, the corner conductors 20 provide access to one or more of other conductive paths of the substrate 12. As a result, this design would virtually eliminate any manual wiring on the panel 10a.

It is desirable to have the greatest area possible on the panel 10a dedicated to the solar cells 14 and have small corner regions. However, a desire to provide all possible permutations of cell-to-cell connections in the corner regions will motivate for large corner regions. Balancing these competing interest will depend on the design.

Competition between interests can be avoided by using the power routing module (PRM) 30. The PRM 30 can embody some or all of the corner conductors 20 between the solar cells 14 and can be applied to the corner region. Different versions of the PRM 30 facilitate purpose-made wiring. Moreover, the PRM 30 can shrink the size of the corner region 26, while providing for the needed variation in conducting pathways, as compared to having the conductive paths on the substrate 12.

Printing corner conductors 20 directly into the corner region 26 is another approach to make purpose-made wiring. This requires less conducting pathway options and can be smaller.

Another variation is the possibility of adding a multiplexing switch module (not shown) into the corner regions 26. The multiplexing switch module could be integrated into the substrate 12 or the PRM 30. The multiplexing switch module would be programmed to make the desired electrical pathways between the solar cells 14 and the corner conductors 20.

For example, the multiplexing switch module could be programmed once and "burned in," or could be addressable and altered during operation. When burned-in, the multiplexing switch module may be programmed through a temporary external connection. There may also be additional conductors in the substrate 12 that address and program the operation of all of the multiplexing switch modules that may be installed across the panel 10a. In addition, a multiplexing switch module that can be addressed and operate while in orbit will have great advantages.

The assembly of the solar cells 14 in arrays in this manner will greatly simplify manufacturing and enable automation while preserving the ability for customization. The key is that the electrical connections between adjacent solar cells 14 is completed on the substrate 12 using the corner conductors 20. Thus, the panel 10a layout and manufacturing of the layout is independent of the final design and can be common for virtually any design.

Further, the disclosure comprises examples according to the following clauses:
Clause 1. A solar cell panel, comprising: a solar cell array comprised of one or more solar cells and a substrate for the solar cells, wherein: an area of the substrate remains exposed when at least one of the solar cells having at least one cropped corner is attached to the substrate; the area of the substrate that remains exposed includes one or more corner conductors; and one or more electrical connections between the solar cells and the corner conductors are made in a corner region resulting from the cropped corner of the at least one of the solar cells.
Clause 2. The solar cell panel of Clause 1, wherein the at least one solar cell comprises a plurality of solar cells attached to a substrate such that corner regions of adjacent ones of the solar cells are aligned, thereby exposing an area of the substrate, and the electrical connections between the solar cells are made in the exposed area of the substrate using the corner conductors formed on or in the exposed area of the substrate.
Clause 3. The solar cell panel of Clause 1 or 2, wherein the solar cells are individually attached to the substrate.
Clause 4. The solar cell panel of any one of Clauses 1-3, wherein the solar cells are attached to the substrate as cell, interconnect and coverglass (CIC) units.
Clause 5. The solar cell panel of any one of Clauses 1-4, wherein the corner conductors are attached to, printed on, or integrated with the substrate before the solar cells are attached.
Clause 6. The solar cell panel of any one of Clauses 1-5, wherein the substrate includes conductive paths on its surface, beneath its surface, or both on its surface and beneath its surface.
Clause 7. The solar cell panel of claim 6, wherein the conductive paths are electrically insulated from the solar cells.
Clause 8. The solar cell panel of any one of Clauses 1-7, wherein at least one of the electrical connections between at least one of the solar cells and at least one of the corner conductors is made after the at least one of the solar cells has been attached to the substrate.
Clause 9. A method for fabricating a solar cell panel, comprising: fabricating a solar cell array comprised of one or more solar cells and a substrate for the solar cells, wherein: an area of the substrate remains exposed when at least one of the solar cells having at least one cropped corner is attached to the substrate; the area of the substrate that remains exposed includes one or more corner conductors; and one or more electrical connections between the solar cells and the corner conductors are made in a corner region resulting from the cropped corner of the at least one of the solar cells.
Clause 10. The method of Clause 9, wherein the at least one solar cell comprises a plurality of solar cells attached to a substrate such that corner regions of adjacent ones of the solar cells are aligned, thereby exposing an area of the substrate, and the electrical connections between the solar cells are made in the exposed area of the substrate using the corner conductors formed on or in the exposed area of the substrate.
Clause 11. The method of Clause 9 or 10, wherein the solar cells are individually attached to the substrate.
Clause 12. The method of any one of Clauses 9-11, wherein the solar cells are attached to the substrate as cell, interconnect and coverglass (CIC) units.
Clause 13. The method of any one of Clauses 9-12, wherein the corner conductors are attached to, printed on, or integrated with the substrate before the solar cells are attached.
Clause 14. The method of any one of Clauses 9-13, wherein the substrate includes conductive paths on its surface, beneath its surface, or both on its surface and beneath its surface.
Clause 15. The method of Clause 14, wherein the conductive paths are electrically insulated from the solar cells.
Clause 16. The method of any one of Clauses 9-15, wherein at least one of the electrical connections between at least one of the solar cells and at least one of the corner conductors is made after the at least one of the solar cells has been attached to the substrate.
Clause 17. A device, comprising: at least one solar cell, wherein the solar cell has at least one cropped corner that defines a corner region, such that the corner region resulting from the cropped corner includes at least one contact for making an electrical connection to the solar cell.
Clause 18. The device of Clause 17, wherein the contact comprises a front contact on a front side of the solar cell.
Clause 19. The device of Clause 17 or 18, wherein the contact comprises a back contact on a back side of the solar cell.
Clause 20. The device of any one of Clauses 17-19, wherein the contact extends into the corner region.
Clause 21. The device of any one of Clauses 17-20, wherein the at least one solar cell comprises a plurality of solar cells attached to a substrate such that corner regions of adjacent ones of the solar cells are aligned, thereby exposing an area of the substrate, and electrical connections between the solar cells are made in the exposed area of the substrate using corner conductors formed on or in the exposed area of the substrate.
Clause 22. The device of Clause 21, wherein the electrical connections are series connections that determine a flow of power through the solar cells.
Clause 23. The device of Clause 22, wherein the series connections are up/down series connections.
Clause 24. The device of Clause 22, wherein the series connections are left/right series connections.
Clause 25. The device of Clause 21, wherein one or more bypass diodes are added to the exposed area of the substrate for use in one or more of the electrical connections.
Clause 26. The device of any one of Clauses 17-25, wherein a bypass diode is applied to a back side of the cell, with an interconnect or contact for the bypass diode extending into the corner region.
Clause 27. A method, comprising: fabricating at least one solar cell, wherein the solar cell has at least one cropped corner that defines a corner region, such that the corner region resulting from the cropped corner includes at least one contact for making an electrical connection to the solar cell.
Clause 28. The method of Clause 27, wherein the contact comprises a front contact on a front side of the solar cell.
Clause 29. The method of Clause 27 or 28, wherein the contact comprises a back contact on a back side of the solar cell.
Clause 30. The method of any one of Clauses 27-29, wherein the contact extends into the corner region.
Clause 31. The method of any one of Clauses 27-30, wherein the at least one solar cell comprises a plurality of solar cells attached to a substrate such that corner regions of adjacent ones of the solar cells are aligned, thereby exposing an area of the substrate, and electrical connections between the solar cells are made in the exposed area of the substrate using corner conductors formed on or in the exposed area of the substrate.
Clause 32. The method of Clause 31, wherein the electrical connections are series connections that determine a flow of current through the solar cells.
Clause 33. The method of Clause 32, wherein the series connections are up/down series connections.
Clause 34. The method of Clause 32, wherein the series connections are left/right series connections.
Clause 35. The method of Clause 31, wherein one or more bypass diodes are added to the exposed area of the substrate for use in one or more of the electrical connections.
Clause 36. The method of any one of Clauses 27-35, wherein a bypass diode is applied to a back side of the cell, with an interconnect or contact for the bypass diode extending into the corner region.

## Claims

1. A device, comprising:
at least one solar cell (14), wherein the solar cell (14) has at least one cropped corner (24) that defines a corner region (26), such that the corner region (26) resulting from the cropped corner (24) includes at least one contact (32, 34) for making an electrical connection to the solar cell (14).

2. The device of claim 1, wherein the contact (32, 34) comprises a front contact (32) on a front side of the solar cell (14).

3. The device of claim 1 or 2, wherein the contact (32, 34) comprises a back contact (34) on a back side of the solar cell (14).

4. The device of any one of claims 1-3, wherein the contact (32, 34) extends into the corner region (26).

5. The device of any one of claims 1-4, wherein the at least one solar cell (14) comprises a plurality of solar cells (14) attached to a substrate (12) such that corner regions (26) of adjacent ones of the solar cells (14) are aligned, thereby exposing an area (28) of the substrate (12), and electrical connections between the solar cells (14) are made in the exposed area (28) of the substrate (12) using corner conductors (20) formed on or in the exposed area (28) of the substrate (12).

6. The device of claim 5, wherein the electrical connections are series connections (48, 50) that determine a flow of power through the solar cells (12), and wherein the series connections (48, 50) preferably are up/down series connections (48) or left/right series connections (50).

7. The device of claim 5, wherein one or more bypass diodes (44) are added to the exposed area (28) of the substrate (12) for use in one or more of the electrical connections.

8. The device of any one of claims 1-7, wherein a bypass diode (44) is applied to a back side of the cell (14), with an interconnect or contact (46) for the bypass diode (44) extending into the corner region (26).

9. A method, comprising:
fabricating at least one solar cell (14), wherein the solar cell (14) has at least one cropped corner (24) that defines a corner region (26), such that the corner region (26) resulting from the cropped corner (24) includes at least one contact (32, 34) for making an electrical connection to the solar cell (14).

10. The method of claim 9, wherein the contact (32, 34) comprises a front contact (32) on a front side of the solar cell (14), and/or wherein the contact (32, 34) comprises a back contact (34) on a back side of the solar cell (14).

11. The method of any one of claims 9-10, wherein the contact (32, 34) extends into the corner region (26).

12. The method of any one of claims 9-11, wherein the at least one solar cell (14) comprises a plurality of solar cells (14) attached to a substrate (12) such that corner regions (26) of adjacent ones of the solar cells (14) are aligned, thereby exposing an area (28) of the substrate (12), and electrical connections between the solar cells (14) are made in the exposed area (28) of the substrate (12) using corner conductors (20) formed on or in the exposed area (28) of the substrate (12).

13. The method of claim 12, wherein the electrical connections are series connections (48, 50) that determine a flow of current through the solar cells (14), wherein the series connections (48, 50) preferably are up/down series connections (48) or left/right series connections (50).

14. The method of claim 12, wherein one or more bypass diodes (44) are added to the exposed area (28) of the substrate (12) for use in one or more of the electrical connections.

15. The method of any one of claims 9-14, wherein a bypass diode (44) is applied to a back side of the cell (14), with an interconnect or contact (46) for the bypass diode (44) extending into the corner region (26).
